# FASCICULE DE BREVET EUROPEEN

(11) **EP 3 671 873 B1**
(45) Date de publication et mention de la délivrance du brevet: **17.03.2021**
(21) Numéro de dépôt: 19217095.9
(22) Date de dépôt: 17.12.2019
(51) Int. Cl.: H01L 41/09

(54) **MICROSYSTEME ELECTROMECANIQUE COMPRENANT UN ELEMENT ACTIF POURVU D'UNE COUCHE COEUR STRUCTUREE**
ELEKTROMECHANISCHES MIKROSYSTEM, DAS EIN AKTIVES ELEMENT MIT EINER STRUKTURIERTEN KERNSCHICHT UMFASST
ELECTROMECHANICAL MICROSYSTEM COMPRISING AN ACTIVE ELEMENT PROVIDED WITH A STRUCTURED CORE LAYER

(30) Priorité: 18.12.2018 FR 1873251
(43) Date de publication de la demande: 24.06.2020
(73) Titulaire: Commissariat à l'énergie atomique et aux énergies alternatives, 75015 Paris (FR)
(72) Inventeur: HILT, Thierry, 38054 GRENOBLE CEDEX 09 (FR); FANGET, Stéphane, 38054 GRENOBLE CEDEX 09 (FR); JOET, Loïc, 38054 GRENOBLE CEDEX 09 (FR)
(74) Mandataire: Brevalex

(56) Documents cités:
- EP-A1- 0 036 187
- JP-A- H06 275 884
- US-A1- 2017 246 662
- US-A1- 2018 078 970

## Description

### DOMAINE TECHNIQUE

L'invention appartient au domaine des systèmes électromécaniques, et notamment des micros systèmes électromécaniques (« MEMS » ou « MicroElectroMechanical System » selon la terminologie Anglo-Saxonne).

En particulier, l'invention concerne un système électromécanique pourvu d'un élément actif formant une poutre ou une membrane susceptible de fléchir sous l'effet d'un signal électrique et inversement.

L'élément actif, selon la présente invention, peut notamment être mis en œuvre pour réaliser une fonction capteur ou une fonction d'actuation.

### ÉTAT DE LA TECHNIQUE ANTÉRIEURE

Les micros systèmes électromécaniques connus de l'état de la technique, qu'ils soient destinés à assurer une fonction de capteur («sensor» selon la terminologie Anglo-Saxonne) ou d'actionneur (« actuator » selon la terminologie Anglo-Saxonne), exercent ladite fonction via un élément actif adapté pour transformer un signal électrique en un signal physique et inversement.

Le signal physique peut notamment comprendre une température (signal thermique), un champ magnétique (signal magnétique), une force ou pression, une sollicitation à distance (gravité, accélération) ou une vibration.

L'élément actif comprend généralement un ensemble multicouche formant par exemple une membrane ou une poutre.

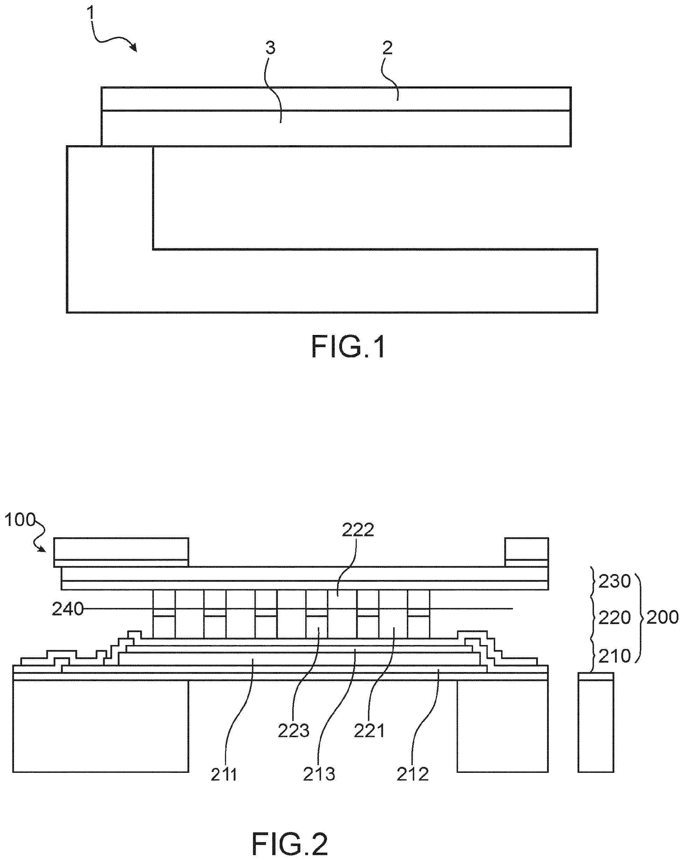

À cet égard, la figure 1 illustre la structure d'un élément actif 1 d'un MEMS connu de l'état de la technique qui comprend, d'une face avant vers une face arrière essentiellement parallèle à la face avant, une couche active 2 reposant sur une couche de maintien 3.

La couche active comprend en particulier un matériau qui est susceptible de subir une déformation et de déformer la poutre ou membrane selon une direction perpendiculaire au plan défini par la face avant dès lors qu'un signal électrique lui est imposé ou inversement.

En particulier, un MEMS fonctionnant en mode capteur verra son élément actif subir une déformation sous l'action d'une contrainte extérieure de sorte que ledit élément actif produise un signal électrique représentatif de ladite contrainte extérieure.

À contrario, un MEMS fonctionnant en mode actuateur verra son élément actif subir une déformation sous l'action d'un signal électrique, de manière à imposer une action mécanique à l'environnement extérieur, par exemple pour faire pivoter un micro miroir.

Le phénomène de flexion de la poutre ou membrane précédemment mentionné répond aux principes énoncés en théorie des poutres et notamment dans le document [1] cité à la fin de la description.

Cette théorie révèle l'existence d'une surface, dite fibre neutre, dans le volume de l'élément actif, parallèle à la face supérieure de l'élément actif et qui ne subit ni allongement ni rétrécissement lors de la flexion dudit élément actif.

La fibre neutre délimite avec la face supérieure et avec la face inférieure, respectivement, une première région et une seconde région, soumises chacune à une contrainte opposée lorsque l'élément actif est en flexion.

Afin de conférer à l'élément actif une rigidité suffisante et compatible avec les fonctions d'actuateur ou de capteur envisagées, la couche de maintien présente en général une épaisseur et/ou une rigidité supérieure à la couche active de sorte que la fibre neutre se trouve dans ladite couche de maintien.

Cette configuration n'est toutefois pas satisfaisante.

En effet, dès lors que le système fonctionne en mode actuateur, la contraction de la couche active, via l'application d'un signal électrique, contribue également à contracter la partie de la couche de maintien se trouvant dans la première région.

Cette perte d'énergie se traduit par une perte d'énergie exercée par la couche active et par voie de conséquence une perte d'efficacité du micro système électromécanique.

De la même manière, dans le cadre d'une application capteur, un tel effet se traduit par une perte de sensibilité dudit capteur.

La solution consistant à réduire la rigidité imposée par la couche de maintien, par exemple en réduisant l'épaisseur de ladite couche, aurait pour conséquence de réduire la force exercée par l'élément actif lorsque que ce dernier est soumis au signal électrique.

Par ailleurs, pour certaines applications, notamment les micro-pompes, ou les hauts parleurs, la tendance est à l'épaississement de l'élément actif.

Les documents US 2017/246662 et EP 0036187 divulguent chacun un microsystème électromécanique.

Ainsi, un objectif de la présente invention est de proposer un micro système électromécanique qui présente une meilleure efficacité énergétique ou une meilleure sensibilité que les micros systèmes électromécaniques connus de l'état de la technique.

Un autre objectif de la présente invention est de proposer un micro système électromécanique pourvu d'un élément actif plus épais que les éléments actifs connus de l'état de la technique sans toutefois dégrader l'efficacité énergétique ou la sensibilité du micro système électromécanique considéré.

### EXPOSÉ DE L'INVENTION

Les objectifs de la présente invention sont, au moins en partie, atteints par un microsystème électromécanique selon les termes de la revendication 1.

En particulier, le système électromécanique est pourvu d'un élément actif apte à réaliser une fonction électromécanique,
l'élément actif comprend, d'une face supérieure vers une face inférieure essentiellement parallèle à la face supérieure, une couche active, une couche cœur et une couche de maintien, la couche active étant adaptée pour, sous l'effet d'un premier signal électrique, passer dans un état mécaniquement contraint, destiné à générer une flexion de l'élément actif selon une direction perpendiculaire à la face avant, et inversement,
la couche active, la couche cœur et la couche de maintien sont agencées de sorte qu'une fibre neutre, associée à un allongement nul en cas de flexion de l'élément actif, se trouve dans le volume de l'une ou l'autre de la couche cœur et de la couche de maintien,
la couche cœur comprend en outre au moins 20%, avantageusement au moins 30%, encore plus avantageusement au moins 50%, d'évidements dans son volume,

Selon un mode de mise en œuvre, les évidements sont compris dans une section de volume délimitée par la fibre neutre et une interface formée entre la couche active et la couche cœur,
la couche cœur comprend des piliers qui comprennent un métal, espacés les uns des autres, et qui s'étendent avantageusement, selon leur plus grande dimension dite hauteur H, entre les deux interfaces que ladite couche cœur forme avec la couche active et la couche de maintien.

Selon un mode de mise en œuvre, les évidements sont compris dans une section de volume délimitée par la fibre neutre et une interface formée par la couche cœur et la couche de maintien.

Selon un mode de mise en œuvre, les évidements sont répartis régulièrement dans tout de volume de la couche cœur.

Selon un mode de mise en œuvre, les évidements forment des ouvertures traversantes débouchant sur chacune des interfaces que ladite couche cœur forme avec, respectivement, la couche active et la couche de maintien.

Selon un mode de mise en œuvre, la couche de maintien et la couche cœur sont faites du même matériau

Selon un mode de mise en œuvre, les piliers comprennent un métal, avantageusement le métal comprend au moins une des espèces choisies parmi : cuivre, nickel.

Selon un mode de mise en œuvre, la couche active comprend une couche matériau piézoélectrique.

Selon un mode de mise en œuvre, la couche active comprend en outre deux électrodes sous forme de couches entre lesquelles est intercalée la couche de matériau piézoélectrique, et qui sont destinées à appliquer le premier signal électrique sur la couche de matériau piézoélectrique.

Selon un mode de mise en œuvre, la couche de maintien est adaptée pour, lorsqu'elle est soumise à un second signal électrique, passer dans un état mécaniquement contraint opposé à l'état contraint de la couche active lorsque cette dernière est soumise au premier signal électrique.

Selon un mode de mise en œuvre, l'élément actif est une poutre.

Selon un mode de mise en œuvre, l'élément actif comprend une membrane.

L'invention concerne également un microsystème électromécanique pourvu d'un élément actif apte à réaliser une fonction électromécanique,
l'élément actif comprend, d'une face supérieure vers une face inférieure essentiellement parallèle à la face supérieure, une couche active, une couche cœur et une couche de maintien, la couche active étant adaptée pour, sous l'effet d'un signal électrique, passer dans un état mécaniquement contraint, avantageusement un état de compression, destiné à générer une flexion de l'élément actif selon une direction perpendiculaire à la face avant, et inversement,
la couche active, la couche cœur et la couche de maintien sont agencées de sorte que la fibre neutre, associée à un allongement nul en cas de flexion de l'élément actif, se trouve dans le volume de l'une ou l'autre de la couche cœur et de la couche de maintien
la couche cœur, comprend un matériau mécaniquement anisotrope, avantageusement orthotrope, agencé de sorte que sa direction de plus grande rigidité soit normale à la face avant.

Selon un mode de mise en œuvre, la couche active comprend une couche de matériau piézoélectrique.

Selon un mode de mise en œuvre, la couche active comprend en outre deux électrodes sous forme de couches entre lesquelles est intercalée la couche de matériau piézoélectrique, et qui sont destinées à appliquer le premier signal électrique sur la couche de matériau piézoélectrique.

Selon un mode de mise en œuvre, la couche de maintien est adaptée pour, lorsqu'elle est soumise à un second signal électrique, passer dans un état mécaniquement contraint opposé à l'état contraint de la couche active lorsque cette dernière est soumise au premier signal électrique.

Selon un mode de mise en œuvre, l'élément actif est une poutre.

Selon un mode de mise en œuvre, l'élément actif comprend une membrane.

### BRÈVE DESCRIPTION DES DESSINS

D'autres caractéristiques et avantages apparaîtront dans la description qui va suivre d'un microsystème électromécanique selon l'invention, donnés à titre d'exemples non limitatifs, en référence aux dessins annexés dans lesquels :
- la figure 1 est une représentation d'un élément actif au repos d'un MEMS connu de l'état de la technique, l'élément actif est notamment représenté en coupe selon un plan perpendiculaire à la face avant dudit élément ;
- la figure 2 est une représentation schématique de l'élément actif selon un mode de réalisation de la présente invention, la représentation est notamment établie selon un plan de coupe perpendiculaire aux faces principales de l'élément actif ;
- les figures 3a à 3k sont des représentations schématiques d'un procédé de fabrication d'un microsystème électromécanique selon la présente invention.

### EXPOSÉ DÉTAILLÉ DE MODES DE RÉALISATION PARTICULIERS

La présente invention décrite de manière détaillée dans la suite de l'énoncé concerne un microsystème électromécanique pourvu d'un élément actif fait d'un empilement qui comprend, d'une face supérieure vers une face inférieure, une couche active, une couche cœur et une couche de maintien destinée à assurer un maintien mécanique dudit élément actif.

La couche cœur, selon les termes de la présente invention, est structurée de manière à conférer à ladite couche une rigidité anisotrope.

En particulier, la couche cœur présente une rigidité selon une direction perpendiculaire à la face avant supérieure à sa rigidité selon une direction parallèle à cette même face.

Par ailleurs, les couches formant l'élément actif sont dimensionnées en termes d'épaisseur et/ou de propriétés mécaniques de manière à ce que la fibre neutre se situe soit dans le volume de la couche cœur soit dans celui de la couche de maintien.

Selon un mode de réalisation particulier de l'invention, la fibre neutre peut être dans le volume de la couche cœur, par exemple à proximité de l'interface formée entre la couche cœur et la couche de maintien.

Un positionnement de la fibre neutre à mi-distance entre la couche active et la couche de maintien peut également être considéré notamment si la couche de maintien est également active.

La localisation de la fibre neutre selon les termes de l'invention permet notamment de minimiser l'effort nécessaire à la flexion de l'élément actif.

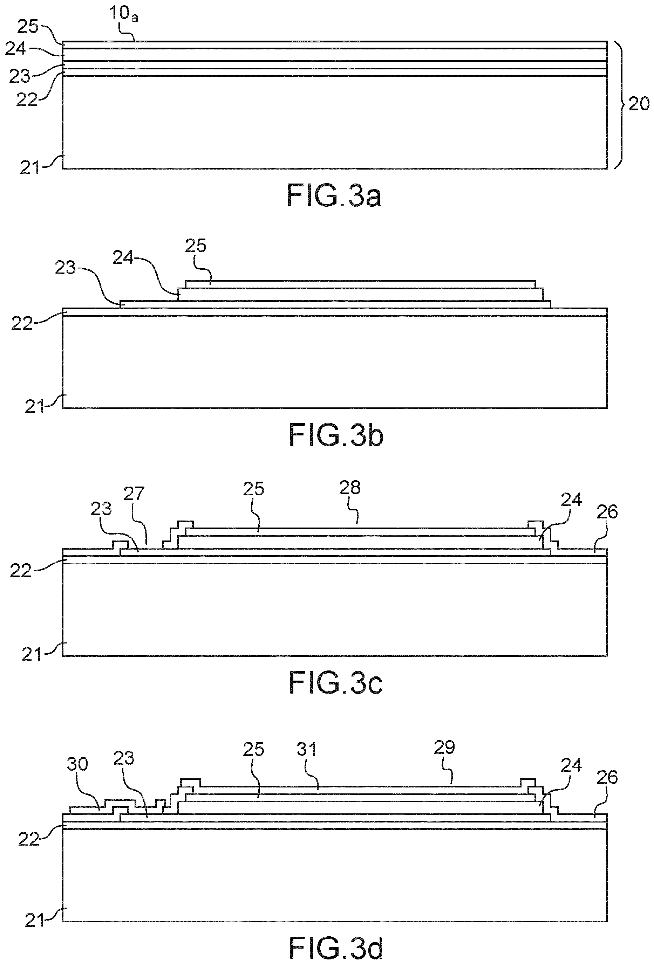

Les figures 2, et 3a à 3k représentent un microsystème électromécanique 100 selon les termes de la présente invention.

Le microsystème électromécanique peut assurer, via un élément actif 200, soit une fonction de capteur, tel un microphone, soit une fonction d'actuateur, pour le déplacement de micro miroirs par exemple.

L'élément actif 200 comprend deux faces principales dites, respectivement, face supérieure et face inférieure essentiellement parallèles entre elles.

L'élément actif 200 peut prendre la forme d'une poutre ou d'une membrane.

Il est entendu sans qu'il soit nécessaire de le préciser que l'élément actif 200, quel que soit sa forme, est généralement maintenu selon un ou plusieurs de ses bords à un support.

L'élément actif 200 comprend, de sa face supérieure vers sa face inférieure, une couche active 210, une couche cœur 220, et une couche de maintien 230.

La couche active 210 est en particulier adaptée pour voir son état de contrainte varier dès qu'un signal électrique, dit premier signal électrique, lui est imposé et inversement.

Le changement d'état de contrainte peut comprendre une mise en compression ou une mise en tension de la couche active 210.

Le premier signal électrique peut comprendre une tension imposée à la couche active, imposée notamment sur chacune des faces de la couche active 210.

À cet égard, la couche active 210 peut comprendre une couche de matériau piézoélectrique 211 ainsi que deux électrodes 212, 213 en recouvrement de chacune des faces de ladite couche de matériau piézoélectrique 211.

Les deux électrodes 212 et 213 sont notamment destinées à imposer une tension électrique entre chacune des faces principales de la couche de matériau piézoélectrique.

La couche de matériau piézoélectrique 211 peut comprendre au moins l'un des matériaux piézoélectriques choisi parmi : PZT, AIN, LNO.

La couche de matériau piézoélectrique peut présenter une épaisseur comprise entre 10nm et 5mm.

Un élément actif 210 sous forme de poutre peut présenter une longueur comprise entre 100nm et 20mm, et une largeur comprise entre 100nm et 20mm.

La largeur et la longueur d'un élément actif 210 formant une poutre sont, selon la présente invention, les dimensions de sa face supérieure et de sa face inférieure.

Un élément actif 210 sous forme de membrane peut être de forme ronde, carrée, rectangulaire ou trapézoïdale.

L'élément actif 210 peut également prendre la forme d'une spirale. Selon cette configuration il est possible de considérer un ruban de grande longueur enroulé sur lui-même, et occupant donc un espace réduit.

Les électrodes peuvent présenter une épaisseur comprise entre 1nm et 100µm, et comprendre au moins un des éléments choisi parmi : Cu, Mo, Pt, Ru, Al, Ni, Au.

La couche de maintien 230 assure la tenue mécanique de l'ensemble formé par la couche active 210, la couche cœur 220, et ladite couche de maintien 230.

La couche de maintien 230 peut comprendre au moins un des matériaux choisi parmi : Silicium, Cu, Ni, Al.

La couche de maintien 230 peut présenter une épaisseur comprise entre 1µm et 1mm.

De manière particulièrement avantageuse, la couche de maintien 230 peut être adaptée pour, lorsqu'elle est soumise à un second signal électrique, passer dans un état mécaniquement contraint opposé à l'état contraint de la couche active 210 lorsque cette dernière est soumise au premier signal électrique.

La couche cœur 220 est agencée, avec la couche de maintien 230, de sorte qu'une fibre neutre 240 associée à un allongement nul en cas de flexion de l'élément actif 200, se trouve dans le volume de la couche cœur ou de la couche de maintien.

L'homme du métier, avec ses connaissances générales, est à même de dimensionner la couche cœur 220 en termes d'épaisseur et de propriétés mécaniques en vue de positionner la fibre neutre dans l'une ou l'autre de la couche cœur ou de la couche de maintien.

Selon un premier mode de réalisation, la couche cœur 220 peut comprendre au moins 20%, avantageusement au moins 30%, encore plus avantageusement au moins 50%, d'évidements 221.

Les évidements 221 peuvent être compris dans une section de volume délimitée par la fibre neutre 240 et une interface formée entre la couche active 220 et la couche cœur 220.

Alternativement, les évidements 221 peuvent être compris dans une section de volume délimitée par la fibre neutre 240 et une interface formée entre la couche cœur (220) et la couche de maintien 230.

Par « évidement », on entend par exemple des cavités, en d'autres termes des zones de la couche cœur 220 dépourvues de matière.

Les évidements 221 présents dans la section d'évidement 222, permettent de réduire l'effort nécessaire à la flexion de la couche cœur 220 dans la section d'évidement 222.

Les évidements 221 peuvent être régulièrement répartis dans la section d'évidement 222, et plus particulièrement dans tout le volume de la couche cœur 220.

En particulier, les évidements 221 forment des ouvertures traversantes débouchant sur chacune des interfaces que ladite couche cœur 220 forme avec, respectivement, la couche active 210 et la couche de maintien 230.

Notamment, les ouvertures traversantes correspondent à des espaces ménagés entre des piliers 223 qui forment la couche cœur 220.

En d'autres termes, la couche cœur 220 comprend des piliers, espacés les uns des autres, qui s'étendent, selon leur plus grande dimension, dite hauteur H, entre les deux interfaces que ladite couche cœur 220 forme avec la couche active 210 et la couche de maintien 230.

La hauteur H des piliers 223 peut être comprise entre 5µm et 1mm.

Les piliers 223 peuvent également présenter un rapport d'aspect, défini par le rapport entre leur hauteur H et leur largeur ou diamètre, compris entre 0.1 à 30.

Les piliers 223 peuvent par ailleurs être métalliques.

En particulier, les piliers 223 peuvent comprendre au moins l'un des éléments choisi parmi : cuivre, nickel, aluminium.

Selon un second mode de réalisation, la couche cœur 220 peut comprendre un matériau mécaniquement anisotrope, avantageusement orthotrope, agencé de sorte que sa direction de plus grande rigidité soit normale à la face avant.

Par « mécaniquement anisotrope », on entend un matériau qui présente une rigidité anisotrope.

En particulier, la rigidité selon la direction normale à la face avant est nommée rigidité normale par opposition à la rigidité dans un plan défini par la face avant, nommée rigidité parallèle.

Par « matériau orthotropique », on entend un matériau qui présente une rigidité anisotrope selon trois axes principaux orthogonaux.

En particulier, la rigidité normale peut être dix fois supérieure à la rigidité parallèle.

Un matériau peut présenter naturellement des propriétés orthotropiques, et comprendre au moins un matériau cristallin.

Un matériau orthotropique peut également être le résultat d'un mélange de matériaux. Par exemple, la couche cœur 220 peut comprendre un matériau massif dans lequel sont noyées des fibres orientées ou des particules orientées selon une direction normale à la face avant.

Les figures 3a à 3k illustrent les différentes étapes d'un procédé de fabrication d'un microsystème électromécanique qui comprend une couche cœur faite de piliers selon le premier mode de mise en œuvre. Toutefois, l'homme du métier avec ses connaissances générales pourra adapter ce procédé de fabrication dans le cadre du second mode de réalisation.

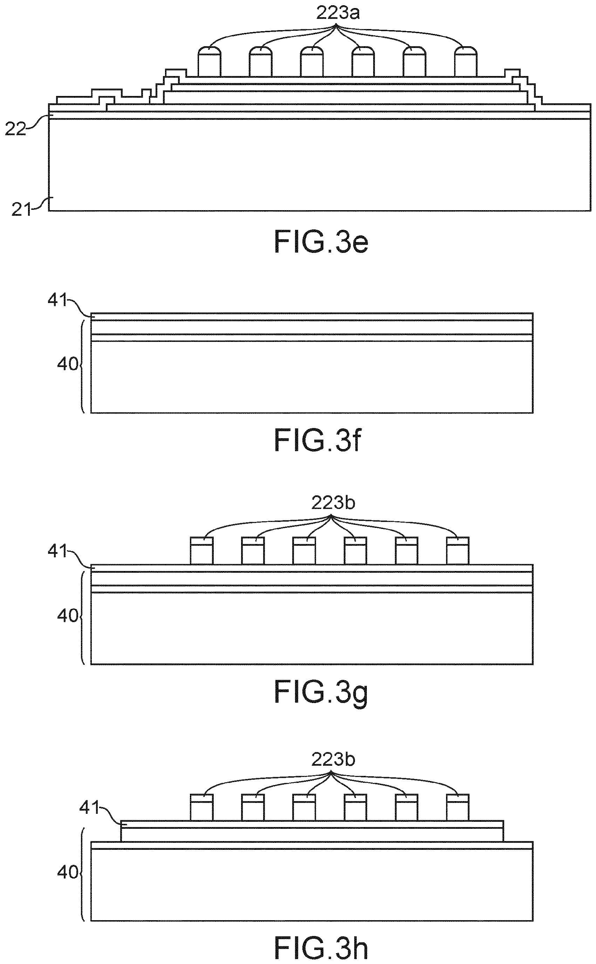

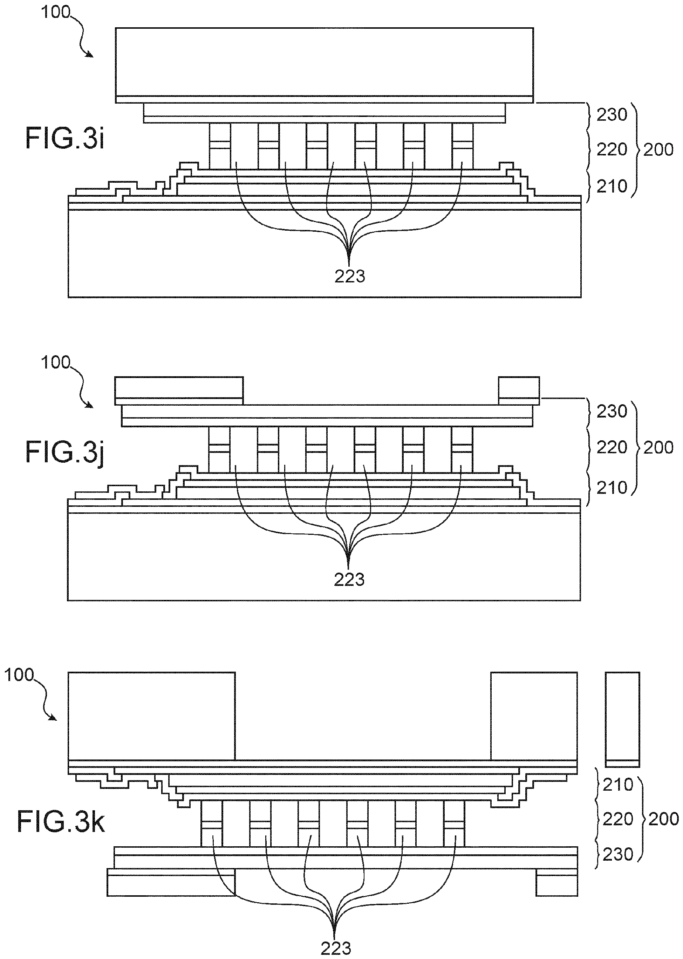

Le procédé de fabrication comprend alors les étapes suivantes.
a) Une étape a) qui comprend la formation d'un empilement de couches 20, destiné à former la couche active 210, sur une première face 10a d'un premier substrat, notamment un substrat de silicium (figure 3a).
   L'empilement de couches 20 comprend notamment, à partir de la première face 10a :
   - une couche d'oxyde thermique 21 ;
   - une couche d'oxyde de titane 22 ;
   - une couche de platine 23 destinée à former, avec la couche d'oxyde de titane, une électrode ;
   - une couche de matériau piézoélectrique 24 qui comprend du titanozirconate de plomb ;
   - une couche de ruthénium 25, destinée à former une électrode.
b) L'étape a) est alors suivie d'une étape b) qui comprend une étape de gravure de l'empilement des couches destinées à délimiter l'étendue de la couche active (figure 3b).
c) Une étape c) de définition de reprises de contact au niveau des électrodes formées par la couche de platine 23 et la couche de ruthénium 25 (figure 3c).
   Cette étape c) comprend notamment la formation d'une couche de passivation 26, par exemple de l'oxyde de silicium, et la formation d'ouvertures 27, 28 dans ladite couche, par gravure, afin d'accéder aux électrodes.
d) Une étape d) de formation de reprises de contact au niveau des ouvertures 27, 28 formées dans la couche de passivation 26.
   L'étape d) comprend à cet égard la formation d'une couche d'or et de titane 29, suivie d'une gravure de ladite couche destinée à délimiter les reprises de contact 30, 31 (figure 3d).
e) Une étape e) de formation de premiers demi-piliers 223a destinés à former, avec des seconds demi piliers 223b, les piliers de la couche cœur 220 (figure 3e).
   L'étape e) de formation des premiers demi-piliers 223a comprend en particulier une étape d'électrodéposition.
f) Une étape f) qui consiste à fournir un second substrat 40, notamment un substrat de silicium sur isolant. Le second substrat comprend également, sur sa couche silicium, une couche d'oxyde de silicium 41 (figure 3f).
g) une étape g) de formation des seconds demi-piliers 223b, sur la couche d'oxyde de silicium 41 (figure 3g). Les seconds demi-piliers 223b sont agencés de manière à être en correspondance avec les premiers demi-piliers 223a.
   L'étape g) comprend une étape d'électrodéposition.
h) une étape h) de gravure de manière à délimiter la couche de maintien 230 dans l'empilement formé par la couche de silicium du second substrat 40, et par la couche d'oxyde de silicium 41 (figure 3h).
i) une étape i) d'assemblage du premier substrat et du second substrat qui comprend une mise en contact des premiers demi-piliers avec les seconds demi-piliers de manière à former les piliers 223 de la couche cœur 220 (figure 3i).

Le procédé comprend enfin des étapes de gravure du premier substrat (figure 3j) et du second substrat (figure 3k) destinées à libérer partiellement l'élément actif.

L'élément actif 200 selon l'un ou des deux modes de réalisation présentés dans la présente invention, confère au microsystème électromécanique une meilleure efficacité énergétique.

En effet, quel que soit le mode de réalisation présenté, la première région délimitée par la fibre neutre et la couche active présente une rigidité selon une direction parallèle à la face avant contrôlée. Il est ainsi possible de faire fléchir l'élément actif sans toutefois dissiper une énergie trop importante au niveau de cette première région.

Une rigidité normale plus élevée permet par ailleurs à l'élément actif de produire une force importante.

La mise en œuvre de la couche cœur permet également d'envisager des éléments actifs plus épais que ceux connus de l'état de la technique.

### REFERENCES

[1] : Jean-Louis Fanchon, Guide de mécanique, Nathan, 2001 (ISBN 2-09-178965-8),

## Revendications

1. Microsystème électromécanique (100) pourvu d'un élément actif (200) apte à réaliser une fonction électromécanique,
l'élément actif (200) comprend, d'une face supérieure vers une face inférieure essentiellement parallèle à la face supérieure, une couche active (210), une couche cœur (220) et une couche de maintien (230), la couche active (210) étant adaptée pour, sous l'effet d'un premier signal électrique, passer dans un état mécaniquement contraint, destiné à générer une flexion de l'élément actif (200) selon une direction perpendiculaire à la face avant, et inversement,
la couche active (210), la couche cœur (220) et la couche de maintien (230) sont agencées de sorte qu'une fibre neutre (240), associée à un allongement nul en cas de flexion de l'élément actif (200), se trouve dans le volume de l'une ou l'autre de la couche cœur (220) et de la couche de maintien (230),
la couche cœur (220) comprend en outre au moins 20%, avantageusement au moins 30%, encore plus avantageusement au moins 50%, d'évidements (221) dans son volume, **caractérisé en ce que** la couche cœur (220) comprend en outre des piliers (223), qui comprennent un métal, espacés les uns des autres, qui s'étendent, selon leur plus grande dimension dite hauteur H, entre les deux interfaces que ladite couche cœur (220) forme avec la couche active (210) et la couche de maintien (230).

2. Microsystème électromécanique selon la revendication 1, dans lequel les évidements (221) sont compris dans une section de volume délimitée par la fibre neutre (240) et une interface formée entre la couche active (220) et la couche cœur (220).

3. Microsystème électromécanique selon la revendication 1, dans lequel les évidements (221) sont compris dans une section de volume délimitée par la fibre neutre (240) et une interface formée entre la couche cœur (220) et la couche de maintien (230).

4. Microsystème électromécanique selon l'une des revendications 1 à 3, dans lequel les évidements sont répartis régulièrement dans tout de volume de la couche cœur (220).

5. Microsystème électromécanique selon l'une des revendication 1 à 4, dans lequel les évidements (221) forment des ouvertures traversantes débouchant sur chacune des interfaces que ladite couche cœur (220) forme avec, respectivement, la couche active (210) et la couche de maintien (230).

6. Microsystème électromécanique selon l'une des revendications 1 à 5, dans lequel le métal formant la couche cœur comprend au moins une des espèces choisie parmi : cuivre, nickel.

7. Microsystème électromécanique selon l'une des revendications 1 à 6, dans lequel la couche de maintien (230) et la couche cœur (220) sont faites du même matériau

8. Microsystème électromécanique selon les revendications 1 à 7, dans lequel la couche active (210) comprend une couche de matériau piézoélectrique (211).

9. Microsystème électromécanique selon la revendication 8, dans lequel la couche active (210) comprend en outre deux électrodes (212, 213) sous forme de couches entre lesquelles est intercalée la couche de matériau piézoélectrique (211), et qui sont destinées à appliquer le premier signal électrique sur la couche de matériau piézoélectrique.

10. Microsystème électromécanique selon l'une des revendications 1 à 9, dans lequel la couche de maintien (230) est adaptée pour, lorsqu'elle est soumise à un second signal électrique, passer dans un état mécaniquement contraint opposé à l'état contraint de la couche active (210) lorsque cette dernière est soumise au premier signal électrique.

11. Microsystème électromécanique selon l'une des revendications 1 à 10, dans lequel l'élément actif (200) est une poutre.

12. Microsystème électromécanique selon l'une des revendications 1 à 10, dans lequel l'élément actif (200) comprend une membrane.

## Patentansprüche

1. Elektromechanisches Mikrosystem (100), das mit einem aktiven Element (200) versehen ist, das dazu geeignet ist, eine elektromechanische Funktion auszuführen,
wobei das aktive Element (200) von einer Oberseite zu einer Unterseite hin, die im Wesentlichen parallel zu der Oberseite verläuft, eine aktive Schicht (210), eine Kernschicht (220) und eine Halteschicht (230) enthält, wobei die aktive Schicht (210) dazu ausgelegt ist, unter der Wirkung eines ersten elektrischen Signals in einen mechanisch beanspruchten Zustand überzugehen, der dazu bestimmt ist, eine Biegung des aktiven Elements (200) in einer Richtung senkrecht zur Vorderseite und umgekehrt zu erzeugen,
wobei die aktive Schicht (210), die Kernschicht (220) und die Halteschicht (230) so angeordnet sind, dass eine neutrale Faser (240), die einer Nulldehnung bei Biegung des aktiven Elements (200) zugeordnet ist, im Volumen entweder der Kernschicht (220) oder der Halteschicht (230) liegt, wobei die Kernschicht (220) ferner zumindest zu 20%, vorteilhaft zumindest zu 30%, noch vorteilhafter zumindest zu 50% Ausnehmungen (221) in ihrem Volumen aufweist,
**dadurch gekennzeichnet, dass**
die Kernschicht (220) ferner Säulen (223) enthält, die ein Metall enthalten, voneinander beabstandet sind und sich entlang ihrer größten Abmessung, Höhe H genannt, zwischen den beiden Grenzflächen erstrecken, die die Kernschicht (220) mit der aktiven Schicht (210) und der Halteschicht (230) bildet.

2. Elektromechanisches Mikrosystem nach Anspruch 1,
wobei die Ausnehmungen (221) in einem Volumenabschnitt enthalten sind, der durch die neutrale Faser (240) und eine zwischen der aktiven Schicht (220) und der Kernschicht (220) gebildete Grenzfläche begrenzt ist.

3. Elektromechanisches Mikrosystem nach Anspruch 1,
wobei die Ausnehmungen (221) in einem Volumenabschnitt enthalten sind, der durch die neutrale Faser (240) und eine zwischen der Kernschicht (220) und der Halteschicht (230) gebildete Grenzfläche begrenzt ist.

4. Elektromechanisches Mikrosystem nach einem der Ansprüche 1 bis 3,
wobei die Ausnehmungen gleichmäßig über das gesamte Volumen der Kernschicht (220) verteilt sind.

5. Elektromechanisches Mikrosystem nach einem der Ansprüche 1 bis 4,
wobei die Ausnehmungen (221) Durchgangsöffnungen bilden, die jeweils an den Grenzflächen ausmünden, die die Kernschicht (220) mit der aktiven Schicht (210) bzw. der Halteschicht (230) bildet.

6. Elektromechanisches Mikrosystem nach einem der Ansprüche 1 bis 5,
wobei das die Kernschicht bildende Metall mindestens eine der Spezies, ausgewählt aus Kupfer, Nickel, enthält.

7. Elektromechanisches Mikrosystem nach einem der Ansprüche 1 bis 6,
wobei die Halteschicht (230) und die Kernschicht (220) aus dem gleichen Material bestehen.

8. Elektromechanisches Mikrosystem nach einem der Ansprüche 1 bis 7,
wobei die aktive Schicht (210) eine Schicht aus piezoelektrischem Material (211) enthält.

9. Elektromechanisches Mikrosystem nach Anspruch 8,
wobei die aktive Schicht (210) ferner zwei schichtartige Elektroden (212, 213) enthält, zwischen denen die Schicht aus piezoelektrischem Material (211) angeordnet ist und die dazu bestimmt sind, das erste elektrische Signal an die Schicht aus piezoelektrischem Material anzulegen.

10. Elektromechanisches Mikrosystem nach einem der Ansprüche 1 bis 9,
wobei die Halteschicht (230) dazu ausgelegt ist, bei Beaufschlagung mit einem zweiten elektrischen Signal in einen mechanisch beanspruchten Zustand überzugehen, der dem beanspruchten Zustand der aktiven Schicht (210) bei Beaufschlagung mit dem ersten elektrischen Signal entgegengesetzt ist.

11. Elektromechanisches Mikrosystem nach einem der Ansprüche 1 bis 10,
wobei das aktive Element (200) ein Balken ist.

12. Elektromechanisches Mikrosystem nach einem der Ansprüche 1 bis 10,
wobei das aktive Element (200) eine Membran enthält.

## Claims

1. Micro-electromechanical system (100) provided with an active element (200) capable of carrying out an electromechanical function,
the active element (200) comprises, from an upper face to a lower face substantially parallel to the upper face, an active layer (210), a core layer (220) and a retention layer (230), the active layer (210) being adapted to, under the effect of a first electric signal, go into a mechanically stressed state, intended to generate a bending of the active element (200) in a direction perpendicular to the front face, and vice versa,
the active layer (210), the core layer (220) and the retention layer (230) are arranged so that a neutral axis (240), associated with an elongation of zero in the case of bending of the active element (200), is located in the volume of one or the other of the core layer (220) and of the retention layer (230),
the core layer (220) further comprises at least 20%, advantageously at least 30%, even more advantageously at least 50%, recesses (221) in its volume,
**characterized in that**:
the core layer (220) further comprises pillars (223), that comprise a metal, spaced apart from each other, that extend, according to their largest dimension called height H, between the two interfaces that said core layer (220) forms with the active layer (210) and the retention layer (230).

2. Micro-electromechanical system according to claim 1, wherein the recesses (221) are comprised in a section of volume defined by the neutral axis (240) and an interface formed between the active layer (220) and the core layer (220).

3. Micro-electromechanical system according to claim 1, wherein the recesses (221) are comprised in a section of volume defined by the neutral axis (240) and an interface formed between the core layer (220) and the retention layer (230).

4. Micro-electromechanical system according to one of claims 1 to 3, wherein the recesses are regularly distributed in all the volume of the core layer (220).

5. Micro-electromechanical system according to one of claims 1 to 4, wherein the recesses (221) form through-holes opening onto each of the interfaces that said core layer (220) forms with, respectively, the active layer (210) and the retention layer (230).

6. Micro-electromechanical system according to any of claims 1to 5, wherein the metal forming the core layer comprises at least one of the species chosen from: copper, nickel.

7. Micro-electromechanical system according to one of claims 1 to 6, wherein the retention layer (230) and the core layer (220) are made from the same material.

8. Micro-electromechanical system according to one of claims 1 to 7, wherein the active layer (210) comprises a layer of piezoelectric material (211).

9. Micro-electromechanical system according to claim 8, wherein the active layer (210) further comprises two electrodes (212, 213) in the form of layers between which the layer of piezoelectric material (211) is interposed, and which are intended to apply the first electric signal onto the layer of piezoelectric material.

10. Micro-electromechanical system according to one of claims 1 to 9, wherein the retention layer (230) is adapted to, when it is subjected to a second electric signal, go into a mechanically stressed state opposite to the stressed state of the active layer (210) when the latter is subjected to the first electric signal.

11. Micro-electromechanical system according to one of claims 1 to 10, wherein the active element (200) is a beam.

12. Micro-electromechanical system according to one of claims 1 to 10, wherein the active element (200) comprises a membrane.
